# EUROPÄISCHE PATENTANMELDUNG

(11) **EP 1 420 444 A2**
(43) Veröffentlichungstag der Anmeldung: **19.05.2004**
(21) Anmeldenummer: 03012298.0
(22) Anmeldetag: 12.06.2003
(51) Int. Cl.: H01L 23/31

(54) **Thermischer und mechanischer Schutz von diskreten Bauelementen in einem Schaltungsmodul**

(30) Priorität: 13.11.2002 DE 10252755
(71) Anmelder: ROBERT BOSCH GMBH, 70442 Stuttgart (DE)
(72) Erfinder: Topp, Rainer, 72768 Reutlingen (DE); Henkel, Achim, 72766 Reutlingen (DE)

(57) **Zusammenfassung**

Die Erfindung betrifft ein Schaltungsmodul mit wenigstens einem.auf einer Grundplatte (4) montierten IC-Schaltkreis (1), der von einer Schutzmasse (3) umgeben ist. Um eine Integration von diskreten Bauelementen (2) zu ermöglichen, wird vorgeschlagen, diskrete Bauelemente (2) mit einem Schutzmantel (7) zu umgeben, der das diskrete Bauelement (2) vor der Beanspruchung bei der Herstellung der Schutzmasse (3) schützt.

## Beschreibung

Die Erfindung betrifft ein Schaltungsmodul mit wenigstens einem auf einer Grundplatte montierten IC-Schaltkreis gemäß dem Oberbegriff des Patentanspruchs 1, sowie ein Verfahren zur Herstellung eines solchen Schaltungsmoduls gemäß dem Oberbegriff des Patentanspruchs 6.

Derartige Schaltungsmodule umfassen in der Regel einen oder mehrere auf einer Grundplatte montierte IC-Schaltkreise, die von einer Schutzmasse umgeben sind. Die Schutzmasse bildet das Gehäuse der IC-Schaltkreise und dient insbesondere dem Schutz der Schaltkreise vor elektrischen und mechanischen Belastungen.

Ein solches Schaltungsmodul ist oftmals an eine externe Schaltung angeschlossen, die je nach Applikation ein oder mehrere diskrete Bauelemente, wie z.B. Widerstände oder Kondensatoren aufweisen kann. Die zusätzlichen diskreten Bauelemente sind beispielsweise gehäuste (gemoldete) Drahtbauelemente oder SMD-Bauelemente (SMD: Surface Mounted Device), die auf einer separaten Platine montiert sind.

Zur Vereinfachung einer solchen Schaltungsanordnung wäre es wünschenswert, auch die externen diskreten Bauelemente im Schaltungsmodul zu integrieren. Dies ist jedoch nur bedingt möglich, da die Schutzmasse, welche die IC-Schaltkreise umgibt, in einem Spritzgussverfahren (Moldprozess), wie z.B. Duroplast-Molden hergestellt wird, wobei hohe mechanische und thermische Belastungen auftreten. Beim Duroplast-Molden werden die Bauelemente Drücken von etwa 20-40 bar und Temperaturen von bis zu 180°C ausgesetzt. Die meisten diskreten Bauelemente halten dieser extremen mechanischen und thermischen Belastung nur ungenügend stand.

Es ist daher die Aufgabe der vorliegenden Erfindung, ein gemoldetes (d.h. mit Gehäuse versehenes) Schaltungsmodul, das neben wenigstens einem IC-Schaltkreis wenigstens ein diskretes Bauelement umfaßt, sowie ein entsprechendes Verfahren zur Herstellung eines solchen Schaltungsmoduls zu schaffen.

Gelöst wird diese Aufgabe gemäß der Erfindung durch die im Patentanspruch 1 sowie 6 angegebenen Merkmale. Weitere Ausgestaltungen der Erfindung sind Gegenstand von Unteransprüchen.

Der wesentliche Gedanke der Erfindung besteht darin, ein Schaltungsmodul sowohl mit integrierten Schaltkreisen als auch mit diskreten Bauelementen zu bestücken und die im Schaltungsmodul enthaltenen diskreten Bauelemente vor der Herstellung der Schutzmasse (Molden) mit einem Schutzmantel zu versehen. Dadurch werden die diskreten Bauelemente vor dem starken thermischen und mechanischen Streß bei der Herstellung der Schutzmasse geschützt.

Diskrete Bauelemente können alle Arten von aktiven oder passiven Bauelementen, wie z.B. Widerstände, Kondensatoren, Induktivitäten, Dioden, Transistoren, etc. sein. Gleichfalls sollen Kombinationen solcher Bauelemente, wie z.B. Reihenoder Parallelschaltungen, in dieser Beschreibung als diskrete Bauelemente gelten. Vorzugsweise handelt es sich um SMD-Bauelemente oder um gehäuste (gemoldete) Drahtbauelemente.

Der Schutzmantel wird vorzugsweise in einem geeigneten Prozess, z.B. in Form kleiner Kunststofftröpfchen, auf die diskreten Bauelemente aufgetragen.

Als Material des Schutzmantels ist z.B. jede Art von Material geeignet, das in der Lage ist, die diskreten Bauelemente ausreichend vor dem thermischem und mechanischem Streß zu schützen, der bei der Herstellung der Schutzmasse auftritt. Der Schutzmantel kann insbesondere aus Kunststoff, einem Si-Gel oder z.B. auch aus einem Heißkleber bestehen.

Der Schutzmantel ist vorzugsweise nur lokal um ein diskretes Bauelement herum angeordnet und ist z.B. halbkugelartig geformt. Die im Schaltungsmodul ebenfalls enthaltenen IC-Schaltkreise müssen nicht ummantelt werden.

Der Schutzmantel besteht vorzugsweise aus einem anderen Material wie die Moldmasse des Modul-Gehäuses.

Die Erfindung wird nachstehend anhand der beigefügten Zeichnungen beispielhaft näher erläutert. Es zeigen:
Fig. 1 ein Schaltungsmodul gemäß einer Ausführungsform der Erfindung mit einem IC-Schaltkreis und einem diskreten Bauelement; und
Fig. 2 ein Flussdiagramm zu Darstellung der wesentlichen Verfahrensschritte bei der Herstellung eines Schaltungsmoduls nach Fig.1.

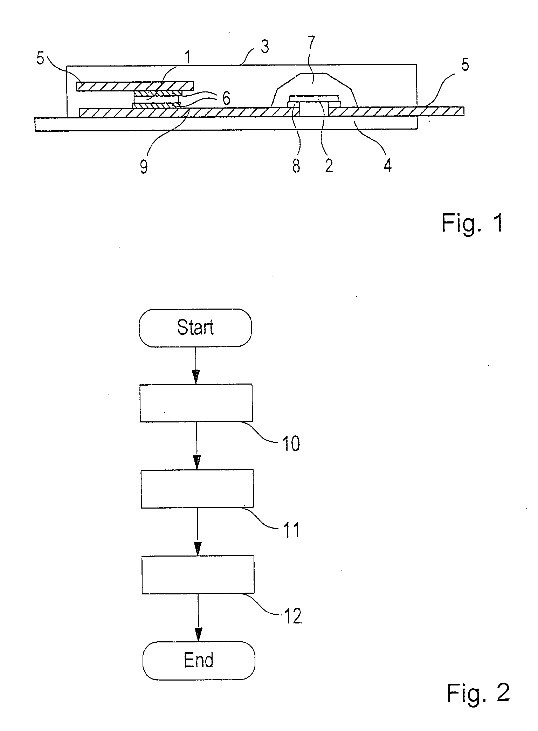

Fig. 1 zeigt ein Schaltungsmodul gemäß einer Ausführungsform der Erfindung mit einem IC-Schaltkreis 1 und einem diskreten Bauelement 2, die auf einer Grundplatte 4 montiert sind.

Der auf der linken Seite gezeigte IC-Schaltkreis 1 ist durch elektrisch leitfähigen Klebstoff oder eine Lotpaste 6 thermisch und elektrisch verbunden. Ein auf der rechten Seite dargestelltes diskretes Bauelement 2 ist über Anschlüsse 8 kontaktiert.

Bei dem diskreten Bauelement 2 kann es sich beispielsweise um ein SMD-Bauelement, wie z.B. einen Widerstand, Kondensator oder eine Induktivität handeln. IC-Schaltkreis 1 und diskretes Bauelement 2 sind über eine elektrische Verbindungsleitung 9 miteinander verbunden.

Das Schaltungsmodul umfaßt ferner zwei Anschlüsse 5 zum Anschluß des Moduls an eine externe Schaltung (nicht gezeigt). Das diskrete Bauelement 2 ist über Kontakte 8 mit der elektrischen Verbindungsleitung 9 bzw. dem externen Anschluss 5 verbunden.

Sowohl der IC-Schaltkreis 1 als auch das diskrete Bauelement 2 sind vollständig in eine Schutzmasse 3 (Moldmasse) eingebettet, die das Gehäuse des Schaltungsmoduls bildet.

Die Schutzmasse 3 wird üblicherweise in einem Spritzgussverfahren (z.B. Duroplast-Molden) hergestellt, wobei extrem hohe Drücke und Temperaturen auftreten. Zum Schutz des diskreten Bauelements 2 ist dieses mit einem halbkugelförmigen Schutzmantel 7 umgeben, der vor der Herstellung der Schutzmasse, im montierten Zustand des diskreten Bauelements, aufgetragen wird. Auf diese Weise wird das diskrete Bauelement 2 sowohl vor thermischem als auch vor mechanischem Streß bei der Herstellung der Schutzmasse 3 geschützt.

Der Schutzmantel 7 besteht vorzugsweise aus Kunststoff, einem Si-Gel oder z.B. auch aus Heißkleber. Das Material des Schutzmantels kann entweder als nachträglich aushärtende Vergussmasse oder als Klebstoff in flüssiger Form aufgebracht werden.

Fig. 2 zeigt die wesentlichen Verfahrensschritte bei der Herstellung eines Schaltungsmoduls. In Schritt 10 werden wenigstens ein IC-Schaltkreis 1 und ein diskretes Bauelement 2 auf einer Grundplatte 4 montiert und elektrisch miteinander verbunden. (Dies kann auch in zwei voneinander getrennten Verfahrensschritten, z.B. Löten und Kleben erfolgen).

Danach wird mittels eines geeigneten Verfahrens ein Schutzmantel 7 auf das diskrete Bauelement 2 aufgebracht (Schritt 11). In Schritt 12 wird schließlich die Schutzmasse 3 hergestellt, welche sowohl den IC-Schaltkreis 1 als auch das ummantelte diskrete Bauelement 2 zumindest teilweise (vorzugsweise vollständig) umgibt.

Die Herstellung der Schutzmasse 3 erfolgt i.d.R. in einem bekannten Moldprozess (Spritzgussverfahren).

### Bezugszeichenliste

- 1: IC-Schaltkreis
- 2: Diskretes Bauelement
- 3: Schutzmasse
- 4: Grundplatte
- 5: Anschlüsse
- 6: Lotpaste/Klebstoff
- 7: Schutzmantel
- 8: Kontakte
- 9: Verbindungsleitung

## Patentansprüche

1. Schaltungsmodul mit wenigstens einem auf einer Grundplatte (4) montierten IC-Schaltkreis (1), der von einer Schutzmasse (3) umgeben ist, **dadurch gekennzeichnet, dass** das Schaltungsmodul ferner wenigstens ein diskretes Bauelement (2) umfaßt, das einen Schutzmantel (7) aufweist, der das diskrete Bauelement (2) vor der Beanspruchung bei der Herstellung der Schutzmasse (3) schützt.

2. Schaltungsmodul nach Anspruch 1, **dadurch gekennzeichnet, dass** die Schutzmasse (3) sowohl den IC-Schaltkreis (1) als auch das von dem Schutzmantel (7) umgebene diskrete Bauelement (2) überdeckt.

3. Schaltungsmodul nach Anspruch 1 oder 2, **dadurch gekennzeichnet, dass** der Schutzmantel (7) in einem Gießverfahren hergestellt wird.

4. Schaltungsmodul nach einem der vorhergehenden Ansprüche, **dadurch gekennzeichnet, dass** der Schutzmantel (7) aus einem Kunststoff, Si-Gel oder Vergussmasse hergestellt ist.

5. Schaltungsmodul nach einem der vorhergehenden Ansprüche, **dadurch gekennzeichnet, dass** der Schutzmantel (7) halbkugelartig gebildet ist.

6. Verfahren zur Herstellung eines Schaltungsmoduls mit wenigstens einem auf einer Grundplatte (4) montierten IC-Schaltkreis (1), **gekennzeichnet durch** folgende Schritte:
- Montieren wenigstens eines IC-Schaltkreises (1) und wenigstens eines diskreten Bauelements (2) auf einer Grundplatte (4);
- Aufbringen eines Schutzmantels (7) auf das diskrete Bauelement (2);
- Herstellen einer Schutzmasse (3), welche den IC-Schaltkreis (1) als auch das ummantelte diskrete Bauelement (2) umgibt.

7. Verfahren nach Anspruch 6, **dadurch gekennzeichnet, dass** die Schutzmasse (3) in einem Spritzgussverfahren hergestellt wird.
